# FASCICULE DE BREVET EUROPEEN

(11) **EP 3 871 478 B1**
(45) Date de publication et mention de la délivrance du brevet: **08.03.2023**
(21) Numéro de dépôt: 19806028.7
(22) Date de dépôt: 16.10.2019
(51) Int. Cl.: H05K 7/20

(54) **DISPOSITIF DE DISSIPATION THERMIQUE, NOTAMMENT POUR DISPOSITIF DE GENERATION D'UN FLUX D'AIR**
VORRICHTUNG ZUR WÄRMEABFUHR, INSBESONDERE FÜR EINE VORRICHTUNG ZUR ERZEUGUNG EINES LUFTSTROMS
HEAT DISSIPATION DEVICE, PARTICULARLY FOR A DEVICE FOR GENERATING AIR FLOW

(30) Priorité: 23.10.2018 FR 1859792
(43) Date de publication de la demande: 01.09.2021
(73) Titulaire: VALEO SYSTEMES THERMIQUES, 78320 Le Mesnil Saint-Denis (FR)
(72) Inventeur: FRANCO, Ismaël, 78322 LE MESNIL SAINT-DENIS CEDEX (FR); RABENJA, Mickaia, 78322 LE MESNIL SAINT-DENIS CEDEX (FR); KAES, Johan, 78322 LE MESNIL SAINT-DENIS CEDEX (FR)
(74) Mandataire: Valeo Systèmes Thermiques
(86) Numéro de dépôt international: PCT/FR2019/052452
(87) Numéro de publication internationale: WO 2020/084223

(56) Documents cités:
- EP-A1- 2 410 830
- DE-A1-102010 002 664
- US-B2- 8 488 318

## Description

L'invention concerne un dispositif de dissipation thermique et un ensemble formé par ledit dispositif et un module électronique de contrôle destiné à être refroidi par ledit dispositif. Elle concerne encore un dispositif d'entrainement électrique comprenant ledit ensemble et un dispositif de génération d'un flux d'air comprenant ledit dispositif d'entrainement. L'invention trouvera ses applications, en particulier, dans des boîtiers de climatisation, notamment des boîtiers de climatisation pour véhicule automobile.

Il est connu des dispositifs de dissipation thermique permettant de refroidir des modules électroniques de contrôle comprenant des dissipateurs thermiques formés dans la masse de boîtiers accueillant lesdits modules. Leurs performances restent décevantes, en particulier en raison des limitations de forme qu'implique la réalisation de ces dissipateurs dans la masse des boîtiers. De plus, cette méthode augmente la quantité de matière nécessaire pour former les boitiers. Par conséquent, le poids et le cout de revient des boitiers sont augmentés, ce qui est pénalisant.

L'invention a pour objectif de pallier au moins en partie les inconvénients précédents et propose à cet effet un dispositif de dissipation thermique comprenant un support et un dissipateur de chaleur, destiné à être refroidi par un flux d'air traversant ledit dissipateur, ledit support présentant un premier logement à l'intérieur duquel ledit dissipateur est maintenu, ledit support étant en outre configuré pour accueillir un module électronique de contrôle, destiné à être refroidi par ledit dissipateur, dans lequel ledit dissipateur est souple.

Grâce audit support, le dissipateur n'est plus réalisé dans la masse d'un boîtier accueillant le module. Sa réalisation est donc beaucoup plus libre et il est possible de lui donner des formes et caractéristiques lui permettant d'offrir des performances améliorées en termes d'échange de chaleur. Par ailleurs, le boîtier accueillant le module peut être simplifié car il n'a plus à assurer une fonction de dissipation thermique.

Diverses caractéristiques supplémentaires peuvent être prévues seules ou selon toutes combinaisons techniquement possibles :
- ledit premier logement présente un fond,
- ledit premier logement présente un ou des côtés latéraux s'étendant à partir dudit fond,
- ledit premier logement est sensiblement parallélépipédique,
- ledit premier logement est configuré pour guider le fluide à travers ledit dissipateur entre une lumière, notamment fente, située dans le fond dudit premier logement et une ouverture située au niveau du ou d'un des côtés latéraux dudit premier logement,
- ledit support présente un second logement destiné à accueillir ledit module électronique,
- ledit second logement est situé à distance dudit premier logement,
- ledit support présente une fenêtre de communication entre lesdits premier et second logements,
- ladite fenêtre accueille un matériau thermiquement conducteur et électriquement isolant,
- ledit matériau est en contact avec ledit dissipateur et destiné à venir en contact avec le module électronique,
- ladite fenêtre est remplie dudit matériau,
- ledit support définit une ceinture entourant ladite fenêtre,
- ledit support comprend une première partie rigide définissant ledit premier logement,
- le support comprend une partie souple, rapportée sur la partie rigide et définissant ledit second logement,
- le dissipateur se présente sous la forme d'une ailette ondulée,
- ladite ailette présente des persiennes destinées à perturber l'écoulement du fluide,
- ledit support est configuré pour accueillir ledit dissipateur de manière amovible,
- ledit support est configuré pour être fixé en vis-à-vis d'un moteur destiné à être contrôlé par ledit module électronique.

L'invention concerne aussi un ensemble formé d'un dispositif de dissipation thermique tel que décrit plus haut et d'un module électronique de commande apte à être refroidi par ledit dispositif.

Diverses caractéristiques supplémentaires peuvent être prévues seules ou selon toutes combinaisons techniquement possibles :
- ledit module comprend une carte électronique et des composants rapportés sur la carte,
- les composants s'étendent d'un côté de la carte opposé à un côté tourné vers le dissipateur,
- la carte comporte un circuit imprimé,
- le matériau thermiquement conducteur et électriquement isolant du dispositif de dissipation thermique est en contact avec le circuit imprimé.

L'invention concerne aussi un dispositif d'entrainement électrique comprenant un moteur électrique et ledit ensemble. Avantageusement, comme déjà dit, ledit module électronique sert au contrôle dudit moteur. Avantageusement encore, la fente éventuellement prévue en fond du premier logement est configurée pour diriger l'air vers une partie du moteur.

L'invention concerne aussi un dispositif de génération d'un flux d'air, notamment pour boîtier de climatisation, comprenant ledit dispositif d'entrainement. Avantageusement, ledit dispositif de génération d'un flux d'air est configuré pour diriger une partie du flux d'air vers le dissipateur.

D'autres particularités et avantages de l'invention apparaîtront encore dans la description ci-après en relation avec les dessins annexés, donnés à titre d'exemples non limitatifs :
- la figure 1 illustre en perspective un exemple de réalisation d'un dispositif de génération de flux d'air selon l'invention
- la figure 2 illustre en vue de dessus un dispositif de dissipation thermique selon l'invention correspondant à celui illustré dans le dispositif de génération de flux d'air de la figure 1,
- la figure 3 illustre en vue de côté le dispositif de dissipation thermique de la figure 2,
- la figure 4 illustre en vue de dessous le dispositif de dissipation thermique des figures 2 et 3,
- la figure 5 illustre en perspective un exemple d'ensemble selon l'invention formé du dispositif de dissipation thermique des figures 2 à 4 et d'un module électronique de commande.

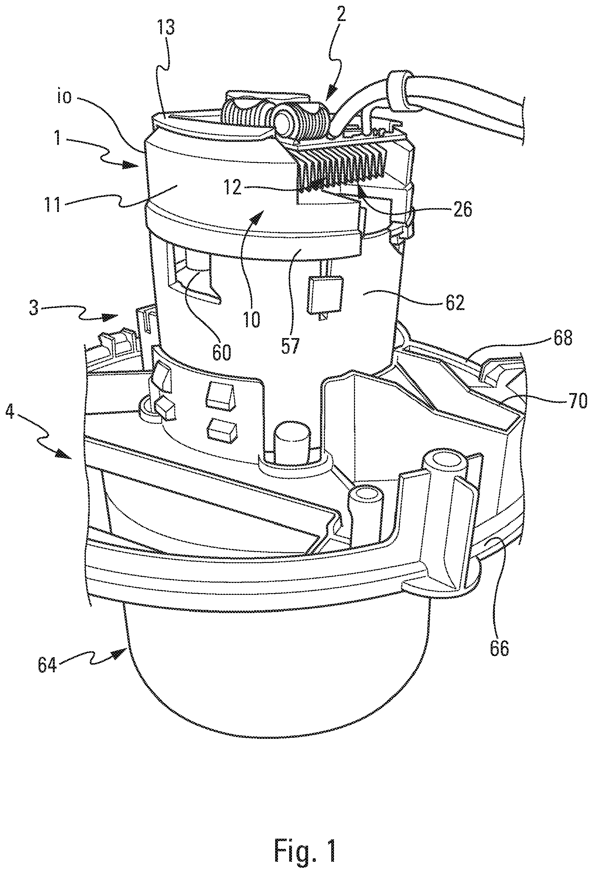

Comme illustré à la figure 1, l'invention concerne un dispositif 1 de dissipation thermique destiné à refroidir un module électronique 2 de commande. Elle trouvera ses applications, notamment, dans des dispositifs d'entrainement électrique 3 et des dispositifs de génération de flux d'air 4, notamment pour système de climatisation, en particulier dans le domaine automobile.

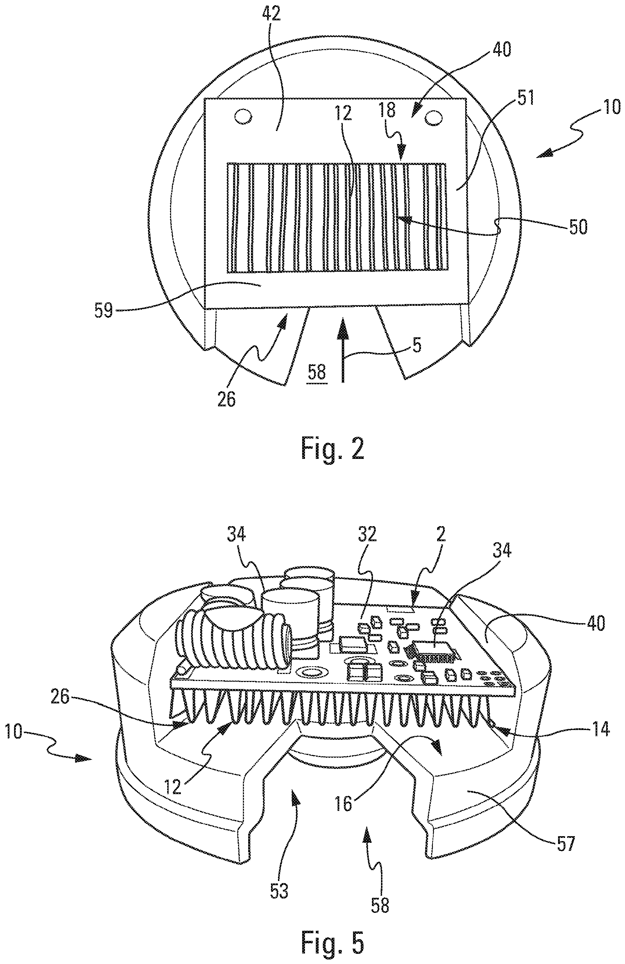

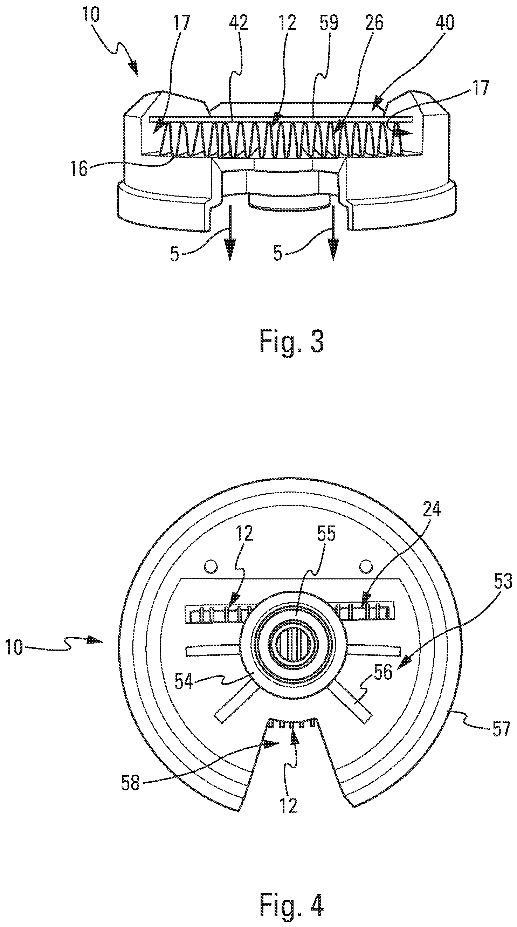

Comme illustré aux figures 2 à 5, ledit dispositif de de dissipation thermique comprend un support 10 et un dissipateur de chaleur 12.

Ledit dissipateur de chaleur 12 est destiné à être refroidi par un flux d'air, illustré par les flèches repérées 5, traversant ledit dissipateur 12. Ledit dissipateur 12 est avantageusement un dissipateur souple. Il se présente, par exemple, sous la forme d'une ailette ondulée. On entend par là une ailette comprenant une succession de zones planes reliées entre elles par des sommets arrondis formant des plis, parallèles entre eux et situés sensiblement dans deux plans différents, les plis se trouvant dans l'un des plans alternant avec des plis se trouvant dans l'autre plan. Ladite ailette pourra présenter des persiennes destinées à perturber l'écoulement du fluide, en particulier situées au niveau des zones planes. L'efficacité de l'échange thermique est ainsi améliorée. Autrement dit, la performance en terme de refroidissement du dissipateur de chaleur 12 est améliorée par la présence des persiennes.

Ledit dissipateur 12, en particulier ladite ailette, est formé, notamment, par déformation d'une plaque métallique, par exemple d'épaisseur comprise entre 50 et 500 micromètres. La plaque est préférentiellement en aluminium ou alliage d'aluminium.

Le dissipateur 12 peut être formé par pliage de la plaque métallique. Le dissipateur souple peut ainsi être fabriqué de manière particulièrement économique, puisqu'il est obtenu par une simple mise en forme d'une plaque de faible épaisseur. Une fois mis en forme, le dissipateur 12 présente une succession de portions planes séparées par une portion courbée. Le rayon de courbure de la portion courbée reliant deux portions planes est compris entre 0,25 et 2 millimètres. Dans le cas où le dissipateur est muni de persiennes, celles-ci sont formées avant la mise en forme des ondulations. La taille et le nombre de persiennes sont choisies de façon à obtenir la performance de refroidissement recherchée pour l'application considérée.

Ledit support 10 présente un premier logement 14 à l'intérieur duquel ledit dissipateur 12 est maintenu. Ledit premier logement 14 présente, par exemple, un fond 16 et des côtés latéraux s'étendant à partir dudit fond 16. Ici, deux desdits côtés latéraux, dit côtés transversaux 17, sont parallèles et opposés l'un à l'autre. Ils sont reliés par un troisième desdits côtés latéraux, dit côté longitudinal 18. Ledit premier logement 12 est par exemple sensiblement parallélépipédique.

Ledit support 10, en particulier ledit premier logement 14, est avantageusement configuré pour accueillir ledit dissipateur de manière amovible. Autrement dit, le dissipateur 12 est mis en place dans le premier logement 14 de façon réversible.

Ledit dissipateur 12 occupe préférentiellement la totalité dudit premier logement 14. Autrement dit, dans le mode de réalisation illustré, deux bords transversaux, opposés, de ladite ailette, à savoir ses bords parallèles aux plis formant ses sommets, sont situés au voisinage des côtés transversaux 17 dudit premier logement 14. Un bord longitudinal de ladite ailette, à savoir un bord ondulé reliant lesdits bords transversaux, est situé au voisinage du côté longitudinal 18 dudit premier logement 14. Une profondeur dudit premier logement 14 correspond sensiblement à une hauteur de ladite ailette, c'est-à-dire, une distance entre les deux plans comprenant les sommets de ladite ailette.

Ledit premier logement 14 est avantageusement configuré pour guider le fluide à travers ledit dissipateur 12 vers une fente 24, située dans le fond 16 dudit premier logement 14, depuis une ouverture latérale 26, s'étendant ici entre les côtés transversaux 17 dudit premier logement 14. Ladite fente 24 s'étend, par exemple, sensiblement perpendiculairement aux plis de l'ailette. L'ouverture 26 s'étend en vis-à-vis d'un bord longitudinal ondulé 22 de l'ailette, opposé au bord longitudinal situé à proximité du côté transversal 18 du premier logement 14. L'air circule entre les plis de l'ailette en provenance de l'ouverture 26 et, perpendiculairement, s'échappe par la fente 24. Autrement dit, la fente 24 et l'ouverture 26 s'étendent dans les plans perpendiculaires. La fente 24 est avantageusement située le long du côté longitudinal 18 dudit premier logement 14 afin de maximiser le trajet de l'air le long de l'ailette.

Ledit support 10 est en outre configuré pour accueillir le module électronique 2 de contrôle (visible figure 5). Ledit module électronique 2 est destiné à être refroidi par ledit dissipateur 12. Ainsi, selon l'invention, ce n'est pas le support 10 qui assure le refroidissement du module électronique 2 mais le dissipateur 12 dont les caractéristiques peuvent être dédiées à cette fonction en laissant au support 10 la fonction d'accueil du module électronique 2. L'efficacité thermique du dissipateur peut de la sorte être optimisée.

Afin d'accueillir ledit module électronique 2, ledit support 10 présente préférentiellement un second logement 40. Dans l'exemple illustré, ledit second logement 40 est lui aussi sensiblement parallélépipédique. Sa surface est ici plus grande que celle du premier logement 14.

Pour des raisons d'isolation électrique, ledit second logement 40 est configuré pour accueillir ledit module électronique 2, à distance dudit premier logement 14. Pour des raisons de compacité, le module électronique 2 est accueilli au niveau d'un fond 42 dudit deuxième logement 40. La distance qui sépare lesdits premier et second logements 14, 40 correspond avantageusement à la distance entre le module électronique 2 et le dissipateur 12. Elle pourra valoir 0,4 mm +/- 0.2 mm. Lesdits premier et second logements 14, 40 s'étendent, par exemple, dans des plans parallèles.

Ledit support 10 présente avantageusement une fenêtre 50 de communication entre lesdits premier et second logements 14, 40. Dans l'exemple illustré, ladite fenêtre 50 se trouve au niveau d'une face du premier logement 14 opposé à son fond 16. Ladite fenêtre 50 est ici de contour rectangulaire. Ledit support 10 définit une ceinture 51, ou cadre, entourant ladite fenêtre 50, préférentiellement de façon continue. Ladite ceinture 51 présente une épaisseur, de préférence constante, qui détermine la distance, évoquée plus haut, entre les premier et second logements 14, 40. Autrement dit, ladite ceinture 51 délimite en partie haute le premier logement 14 et en partie basse ledit deuxième logement 40. Encore autrement dit, ladite ceinture 51 correspond au fond 42 de la deuxième partie 40. Ladite ceinture 51 présente une branche 59 s'étendant le long de l'ouverture 26 pour maintenir l'ailette au niveau de son bord longitudinal ondulé.

Selon un mode de réalisation alternatif, non illustré, ledit support présente plusieurs fenêtres, disjointes, reliant lesdits premier et deuxième logements. Par exemple, ledit support présente au moins deux fenêtres, lesdites fenêtres étant séparées par une portion du support.

La ou lesdites fenêtres accueillent un matériau, non illustré, thermiquement conducteur et électriquement isolant, en contact avec ledit dissipateur 12 et destiné à venir en contact avec le module électronique 2. La ou lesdites fenêtres 50 sont avantageusement remplies dudit matériau thermiquement conducteur et électriquement isolant. En variante, ledit matériau pourra être prévu seulement au niveau des plis de l'ailette ondulée. Dans les deux cas, le dissipateur 12 et le module électrique 2 sont solidarisés au niveau des zones courbes des ailettes, par l'intermédiaire du matériau thermiquement conducteur et électriquement isolant.

Lorsque la ou les fenêtres 50 sont remplies dudit matériau thermiquement conducteur et électriquement isolant, le module électronique n'est pas au contact de l'air traversant le dissipateur thermique. Il n'est donc pas nécessaire de prévoir un revêtement de protection sur la surface du module électronique.

Dans le cas où le matériau thermiquement conducteur et électriquement isolant est appliqué seulement au niveau des zones courbes des ailettes, le module électronique est en contact avec l'air traversant le dissipateur thermique dans les zones dépourvues dudit matériau. Le module électronique doit donc recevoir un revêtement de protection avec d'être solidarisé avec le dissipateur thermique.

Ledit support 10 est avantageusement configuré pour être fixé en vis-à-vis d'un moteur, destiné à être contrôlé par ledit module électronique 2. Pour cela, ici, ledit support comporte un évidement 53 dans lequel ladite fente 24 débouche. Ledit support 10 pourra en outre comprendre un manchon 54 destiné à accueillir un pallier 55 de guidage en rotation d'un arbre, non illustré, dudit moteur. Ledit manchon 54 débouche dans le fond 16 du premier logement 14 et s'étend dans l'évidement 53. Des nervures radiales 56 pourront s'étendre vers une périphérie du support 10 depuis ledit manchon 54. Elles sont liées à un fond de l'évidement 53.

Ledit évidement est ici délimité par une jupe 57 du support 10. Ladite jupe 57 et le fond 16 du premier logement 14 s'interrompent angulairement au niveau de ladite ouverture 26 pour former une échancrure 58 définissant un passage d'air entre le premier logement 14 et l'évidement 53, en amont du dissipateur 12 dans le sens de circulation de l'air.

Le support 10 comprend, par exemple, une première partie 11 rigide et une partie souple 13 (visible figure 1), rapportée sur la partie rigide 11. En variante, la partie souple peut être surmoulée avec la partie rigide. Ladite partie rigide 11 délimite le premier logement 14 ainsi qu'un volume en creux recouvert de ladite partie souple 13. Ledit module électronique 2 est logé dans ladite partie souple 13 qui délimite ledit deuxième logement 40. Ladite fenêtre 50 est définie à travers ladite partie rigide 11 et ladite partie souple 13. Une telle configuration permet un découplage acoustique.

Comme cela est mieux visible à la figure 5, ledit module électronique 2 comprend, par exemple, une carte électronique 32 et des composants 34 rapportés sur la carte 32. Les composants s'étendent, par exemple, d'un côté de la carte 32 opposé à celui tourné vers le dissipateur 12. Ledit matériau thermiquement conducteur et électriquement isolant est alors en contact avec la carte 32, du côté de la carte tournée vers le dissipateur 12. Ladite carte 32 est, par exemple, une carte à circuit imprimé et, dans la configuration évoquée plus haut, le matériau thermiquement conducteur et électriquement isolant est en contact avec le circuit imprimé.

En variante, non illustrée, les composants rapportés sur la carte sont tournés vers le dissipateur. La ceinture de la fenêtre séparant les premier et deuxième logements pourra alors être conformée pour circonscrire lesdits composants.

Si l'on se reporte de nouveau à la figure 1, on constate que l'invention concerne aussi un dispositif 3 d'entrainement électrique comprenant un moteur électrique 60 et l'ensemble formé dudit dispositif de dissipation thermique 1 et dudit module électronique de commande 2. Dans ledit dispositif d'entrainement 3, ledit module électronique 2 sert avantageusement au contrôle dudit moteur 60.

Ledit dispositif d'entrainement 3 comprend ici un boîtier 62, par exemple tubulaire. Ledit boîtier 62 sert de support au moteur 60 et/ou au dispositif de dissipation 1. Dans l'exemple illustré, le moteur 60 est logé à l'intérieur dudit boîtier 62. Le dispositif de dissipation 1 est rapporté sur une extrémité longitudinale dudit boîtier 62, ledit boîtier 62 étant ici emmanché dans la jupe 57 du support 10.

La fente situé dans le fond du premier logement du support 10 permet de la sorte de diriger l'air provenant du dissipateur 12 vers une partie spécifique du moteur, par exemple une partie comprenant des balais de commutation de courant, non visibles.

Toujours à la figure 1, on constate que l'invention concerne encore un dispositif 4 de génération d'un flux d'air, notamment pour boîtier de climatisation, comprenant ledit dispositif d'entrainement 3.

Ledit dispositif 4 de génération d'un flux d'air comprend, par exemple, un ventilateur 64, notamment un ventilateur radial, destiné à générer ledit flux d'air. Il comprend en outre une armature 66 de support du dispositif d'entrainement 3. Ledit ventilateur 64 est monté mobile en rotation autour d'un axe correspondant à un axe longitudinal du boîtier 62. Ladite armature 66 est configurée pour être fixée, par exemple, à un boîtier de climatisation du véhicule automobile. Ainsi, ladite armature 66 est destinée à être fixe et ledit ventilateur 64 est mobile par rapport à ladite armature 66.

Ledit dispositif de génération d'un flux d'air est avantageusement configuré pour diriger une partie du flux d'air généré par le ventilateur 64 vers le dissipateur 12, notamment par l'intermédiaire de l'ouverture 26. Ici, l'air dirigée vers le dissipateur 12 circule longitudinalement le long du boîtier 62 du dispositif d' entrainement, par exemple le long d'une paroi extérieure du boîtier, puis le long du support 10 jusqu'à l'ouverture 26. Une telle circulation est illustrée par la flèche repérée 68. Ledit dispositif 1 de génération d'un flux d'air pourra comprendre pour cela des conduits, non illustrés, s'étendant par exemple d'un orifice 70, situé dans l'armature 66, à l'ouverture 26 prévue latéralement dans ledit support 10.

## Revendications

1. Dispositif de dissipation thermique comprenant un support (10) et un dissipateur de chaleur (12) destiné à être refroidi par un flux d'air traversant ledit dissipateur (12), ledit support (10) présentant un premier logement (14) à l'intérieur duquel ledit dissipateur (10) est maintenu, ledit support (10) étant en outre configuré pour accueillir un module électronique de contrôle (2) destiné à être refroidi par ledit dissipateur (12), **caractérisé en ce que** ledit dissipateur (12) est souple.

2. Dispositif selon la revendication 1 dans lequel ledit premier logement (14) est configuré pour guider le fluide à travers ledit dissipateur (12) entre une fente (24) située dans un fond (16) dudit premier logement (14) et une ouverture (26) située au niveau d'un côté latéral dudit premier logement (14).

3. Dispositif selon la revendication précédente dans lequel ledit support (10) présente un second logement (40) destiné à accueillir ledit module électronique (2), à distance dudit premier logement (14).

4. Dispositif selon la revendication 3 dans lequel ledit support (10) présente une fenêtre (50) de communication entre lesdits premier et second logements (14, 40), ladite fenêtre (50) accueillant un matériau thermiquement conducteur et électriquement isolant, en contact avec ledit dissipateur (12) et destiné à venir en contact avec le module électronique (2).

5. Dispositif selon l'une quelconque des revendications précédentes dans lequel le dissipateur se présente sous la forme d'une ailette ondulée.

6. Ensemble formé d'un dispositif de dissipation thermique (1) selon l'une quelconque des revendications précédentes et d'un module électronique de commande (2) apte à être refroidi par ledit dispositif (1).

7. Ensemble selon la revendication précédente dans lequel ledit module comprend une carte électronique (32) et des composants (34) rapportés sur la carte, les composants (34) s'étendant d'un côte de la carte (32) opposé à celui tourné vers le dissipateur (12).

8. Dispositif d'entrainement électrique comprenant un moteur électrique (60) et l'ensemble selon l'une quelconque des revendications 6 ou 7, ledit module électronique (2) servant au contrôle dudit moteur (60).

9. Dispositif de génération d'un flux d'air, notamment pour boîtier de climatisation, comprenant le dispositif d'entrainement selon la revendication précédente.

## Patentansprüche

1. Wärmeableitvorrichtung, die einen Träger (10) und einen Wärmeableiter (12) enthält, der dazu bestimmt ist, von einem den Ableiter (12) durchquerenden Luftstrom gekühlt zu werden, wobei der Träger (10) eine erste Aufnahme (14) aufweist, in der der Ableiter (10) gehalten wird, wobei der Träger (10) außerdem konfiguriert ist, ein elektronisches Steuermodul (2) aufzunehmen, das dazu bestimmt ist, vom Ableiter (12) gekühlt zu werden, **dadurch gekennzeichnet, dass** der Ableiter (12) biegsam ist.

2. Vorrichtung nach Anspruch 1, wobei die erste Aufnahme (14) konfiguriert ist, das Fluid zwischen einem in einem Boden (16) der ersten Aufnahme (14) befindlichen Schlitz (24) und einer im Bereich einer Seitenfläche der ersten Aufnahme (14) befindlichen Öffnung (26) durch den Ableiter (12) zu leiten.

3. Vorrichtung nach dem vorhergehenden Anspruch, wobei der Träger (10) eine zweite Aufnahme (40) aufweist, die dazu bestimmt ist, das Elektronikmodul (2) in Abstand zur ersten Aufnahme (14) aufzunehmen.

4. Vorrichtung nach Anspruch 3, wobei der Träger (10) ein Fenster (50) zur Verbindung zwischen der ersten und der zweiten Aufnahme (14, 40) aufweist, wobei das Fenster (50) ein thermisch leitendes und elektrisch isolierendes Material aufnimmt, in Kontakt mit dem Ableiter (12) und dazu bestimmt, mit dem Elektronikmodul (2) in Kontakt zu kommen.

5. Vorrichtung nach einem der vorhergehenden Ansprüche, wobei der Ableiter in Form einer Wellenlamelle vorliegt.

6. Einheit bestehend aus einer Wärmeableitvorrichtung (1) nach einem der vorhergehenden Ansprüche und einem elektronischen Steuermodul (2), das von der Vorrichtung (1) gekühlt werden kann.

7. Einheit nach dem vorhergehenden Anspruch, wobei das Modul eine Elektronikkarte (32) und auf die Karte aufgesteckte Bauteile (34) enthält, wobei die Bauteile (34) sich auf einer Seite der Karte (32) entgegengesetzt zu derjenigen erstrecken, die zum Ableiter (12) weist.

8. Elektrische Antriebsvorrichtung, die einen Elektromotor (60) und die Einheit nach einem der Ansprüche 6 oder 7 enthält, wobei das Elektronikmodul (2) zur Steuerung des Motors (60) dient.

9. Vorrichtung zur Erzeugung eines Luftstroms, insbesondere für ein Klimatisierungsgerät, die die Antriebsvorrichtung nach dem vorhergehenden Anspruch enthält.

## Claims

1. Heat-dissipating device comprising a support (10) and a heat sink (12) intended to be cooled by a flow of air passing through said heat sink (12), said support (10) having a first housing space (14) inside which said heat sink (10) is held, said support (10) also being configured to accommodate an electronic control module (2) intended to be cooled by said heat sink (12), **characterized in that** said heat sink (12) is flexible.

2. Device according to Claim 1, wherein said first housing space (14) is configured to guide the fluid through said heat sink (12) between a slot (24) situated in an end wall (16) of said first housing space (14) and an opening (26) situated on a lateral side of said first housing space (14).

3. Device according to the preceding claim, wherein said support (10) has a second housing space (40) intended to accommodate said electronic module (2), some distance from said first housing space (14).

4. Device according to Claim 3, wherein said support (10) has a communication aperture (50) between said first and second housing spaces (14, 40), said aperture (50) accommodating a thermally conducting and electrically insulating material that is in contact with said heat sink (12) and is intended to come into contact with the electronic module (2).

5. Device according to any one of the preceding claims, wherein the heat sink takes the form of a corrugated fin.

6. Assembly formed of a heat-dissipating device (1) according to any one of the preceding claims and of an electronic control module (2) able to be cooled by said device (1).

7. Assembly according to the preceding claim, wherein said module comprises an electronic board (32) and components (34) mounted on the board, the components (34) extending on an opposite side of the board (32) from the side facing towards the heat sink (12).

8. Electronic drive device comprising an electric motor (60) and the assembly according to either one of Claims 6 and 7, said electronic module (2) being used to control said motor (60).

9. Device for generating a flow of air, notably for an air-conditioning housing, comprising the drive device according to the preceding claim.
